# DEMANDE DE BREVET EUROPEEN

(11) **EP 1 248 268 A1**
(43) Date de publication de la demande: **09.10.2002**
(21) Numéro de dépôt: 02005504.2
(22) Date de dépôt: 11.03.2002
(51) Int. Cl.: G11C 16/04, G11C 16/12

(54) **Mémoire EEPROM programmable par mot comprenant des verrous de sélection de colonne à double fonction**

(30) Priorité: 19.03.2001 FR 0103659
(71) Demandeur: STMicroelectronics, 92120 Montrouge (FR)
(72) Inventeur: Bertrand, Bertrand, 13530 Trets (FR); Naura, David, 13090 Aix en Provence (FR); Chehadi, Mohamad, 13090 Aix en Provence (FR)
(74) Mandataire: Marchand, André

(57) **Abrégé**

L'invention concerne une mémoire effaçable et programmable électriquement comprenant des cellules mémoire (CE_{i,j}) connectées à des lignes de mot (WLᵢ) et à des lignes de bit (BLⱼ) agencées en colonnes(COLₖ), des transistors de sélection de lignes de bit (TSBLⱼ) pilotés par des signaux de sélection de lignes de bit (BLSₖ), et des verrous de sélection de colonne (LSCIₖ) recevant chacun un signal de sélection de colonne (SELₖ) et délivrant un signal de contrôle de grille (CGSₖ) appliqué aux cellules mémoire d'une colonne, et comprenant chacun un élément de verrouillage (MEₖ) du signal de sélection de colonne (SELₖ) et des moyens (T12) pour conférer au signal de contrôle de grille (CGSₖ) une valeur contrôlée par l'élément de verrouillage. Selon l'invention, chaque verrou de sélection de colonne (LSCIₖ) comprend des moyens (INV3, T14) pour délivrer, en sus du signal de contrôle de grille (CGSₖ), un signal de sélection de lignes de bit (BLSₖ) dont la valeur est contrôlée par l'élément de verrouillage (MEₖ) au moins pendant des phases de programmation et de lecture de cellules mémoire.

## Description

La présente invention concerne les mémoires effaçables et programmables électriquement, ou mémoires EEPROM.

Les mémoires EEPROM se répartissent en deux grandes catégories : celle des mémoires programmables par page et celle des mémoires programmables par mot, un mot représentant généralement un octet (8 bits) et une page un ensemble de mots appartenant à une même ligne de mot. Les mémoires programmables par page nécessitent un grand nombre de verrous de programmation, et plus particulièrement autant de verrous de programmation que de lignes de bit, pour assurer une programmation simultanée de tous les mots d'une page. Inversement, les mémoires programmables par mot ne nécessitent qu'un nombre de verrous réduit, par exemple huit verrous de programmation pour une mémoire programmable par octet.

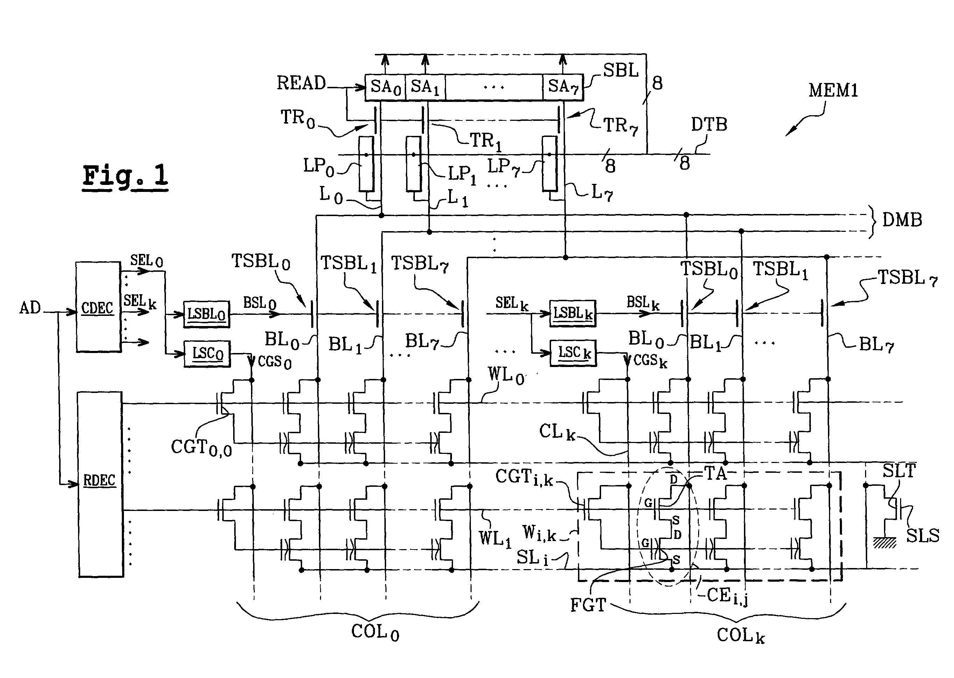

La figure 1 illustre schématiquement l'architecture classique d'une mémoire MEM1 du second type, programmable par mot. La mémoire comprend des lignes de mot WLᵢ, des lignes de bit BLⱼ agencées en colonnes COLₖ, chaque colonne comprenant ici huit lignes de bit BL0 à BL7, et des cellules mémoire CE_{i,j}. Les cellules mémoire CE_{i,j} sont agencées de façon matricielle et connectées aux lignes de mot WLᵢ et aux lignes de bit BLⱼ. Chaque cellule CE_{i,j} comprend un transistor à grille flottante FGT et un transistor d'accès TA. Le transistor d'accès TA a sa grille G connectée à une ligne de mot WLᵢ, son drain D connecté à une ligne de bit BLⱼ, sa source S étant connectée au drain D du transistor FGT. Le transistor FGT a sa grille G reliée à une ligne de sélection de colonne CLₖ par l'intermédiaire d'un transistor de contrôle de grille CGT_{i,k} et sa source S connectée à une ligne de source SLᵢ, la grille du transistor CGT_{i,k} étant connectée à la ligne de mot WLᵢ.

Ainsi, chaque groupe de huit cellules CE_{i,j} connectées à une ligne de mot WLᵢ et aux lignes de bit BL0 à BL7 d'une colonne COLₖ forme un mot W_{i,k} pouvant être sélectionné au moyen de la ligne de sélection de colonne CLₖ et de la ligne de mot WLᵢ correspondantes. A cet effet, les lignes de mot WLᵢ sont connectées aux sorties d'un décodeur de ligne RDEC. Les lignes de sélection de colonne CLₖ sont connectées à des verrous LSCₖ délivrant un signal de contrôle de grille CGSₖ qui est fonction d'un signal de sélection de colonne SELₖ reçu en entrée, le signal SELₖ étant délivré par un décodeur de colonne CDEC. Le décodeur de ligne RDEC et le décodeur de colonne CDEC reçoivent respectivement les bits de poids fort et les bits de poids faible d'une adresse AD appliquée à la mémoire. La ligne de source SLᵢ peut être portée à un potentiel flottant ou être connectée à la masse grâce à un transistor SLT piloté par un signal SLS.

La mémoire MEM1 comprend également huit verrous de programmation LP0 à LP7 dont les sorties sont connectées à des lignes L0 à L7 et huit amplificateurs de lecture SA0 à SA7 ("sense amplifiers") dont les entrées sont connectées aux lignes L0 à L7 par l'intermédiaire de transistors de lecture TR0 à TR7 pilotés par un signal READ. Les sorties des amplificateurs SA0 à SA7 et les entrées des verrous LP0 à LP7 sont connectées à un bus de données DTB, permettant de délivrer des données lues dans la mémoire par les amplificateurs SA0 à SA7 ou de charger dans les verrous de programmation LP0 à LP7 des données à programmer dans la mémoire.

Les lignes L0 à L7 sont reliées aux lignes de bit BL0 à BL7 de chaque colonne COLₖ par l'intermédiaire d'un bus de multiplexage DMB, chaque verrou de programmation LPⱼ de rang j étant ainsi connecté aux lignes de bit de même rang j présentes dans les colonnes. Pour assurer une connexion sélective de la sortie d'un verrou ou de l'entrée d'un amplificateur de lecture à une ligne de bit déterminée, chaque ligne de bit BL0-BL7 de chaque colonne COLₖ est équipée d'un transistor de sélection TSBL0 à TSBL7. Les transistors TSBL0 à TSBL7 de sélection des lignes de bit d'une même colonne COLₖ sont pilotés par un signal de sélection commun BLSₖ, délivré par un verrou LSBLₖ recevant en entrée un signal de sélection de colonne SELₖ issu du décodeur CDEC.

On trouve donc dans chaque colonne de rang k de la mémoire MEM1 un verrou de sélection de colonne LSCₖ et un verrou de sélection de lignes de bit LSBLₖ qui sont pilotés par un signal de sélection de colonne SELₖ commun issu du décodeur CDEC, et qui délivrent un signal de contrôle de grille CGSₖ et un signal de sélection de lignes de bit BLSₖ dont les valeurs sont fonction de la phase en cours d'exécution, à savoir effacement, programmation ou lecture d'une cellule.

Une opération d'effacement ou de programmation d'une cellule mémoire consiste dans l'injection ou l'extraction de charges électriques par effet tunnel (effet Fowler Nordheim) dans la grille flottante du transistor FGT de la cellule. Un transistor FGT effacé présente une tension de seuil positive VT1 et un transistor FGT programmé présente une tension de seuil négative VT2. Lorsqu'une tension de lecture Vread comprise entre VT1 et VT2 est appliquée sur sa grille, un transistor effacé reste bloqué, ce qui correspond par convention à un "1" logique, et un transistor programmé est passant, ce qui correspond par convention à un "0" logique. L'opération d'effacement est réalisée en appliquant une tension d'effacement Vpp de l'ordre de 12 à 20 V sur la grille G du transistor FGT pendant que la ligne de source SLᵢ est portée à la masse. L'opération de programmation est réalisée en appliquant une tension de programmation Vpp sur le drain D du transistor FGT, par l'intermédiaire du transistor d'accès TA, pendant que sa grille est portée à la masse.

Pendant une phase d'effacement des cellules mémoire d'un mot W_{i,k}, le verrou LSCₖ et le verrou LSBLₖ de la colonne concernée sont activés par le signal SELₖ. Le verrou LSCₖ délivre un signal de contrôle de grille CGSₖ égal à Vpp et le verrou LSBLₖ délivre une tension nulle (masse). Pendant une phase de programmation des cellules mémoire du mot W_{i,k}, le verrou LSCₖ délivre au contraire une tension nulle (masse) et le verrou LSBLₖ délivre la tension Vpp afin que les transistors TSBL0 à TSBL7 de la colonne soient passants et relient les sorties des verrous de programmation LPⱼ aux lignes de bit de la colonne. Pendant une phase de lecture du mot W_{i,k}, le verrou LSCₖ délivre une tension de lecture Vread et le verrou LSBLₖ délivre une tension Vcc afin que les transistors TSBL0 à TSBL7 de la colonne soient passants et relient les entrées des amplificateurs de lecture SAⱼ aux lignes de bit de la colonne (les transistors de lecture TRⱼ étant également passants et le signal READ à 1).

Comme cela est mentionné plus haut, l'avantage d'une telle mémoire est de présenter un nombre réduit de verrous de programmation, ici les huit verrous LP0 à LP7, tandis qu'une mémoire programmable par page comprend autant de verrous de programmation que de lignes de bit. En contrepartie, la prévision des transistors TSBL0 à TSBL7 s'avère indispensable pour assurer la connexion d'un verrou de programmation à une ligne de bit déterminée, et la prévision des transistors TSBL0 à TSBL7 implique la prévision des verrous LSBLₖ pour piloter de tels transistors. En d'autres termes, les verrous de sélection de lignes de bit LSBLₖ constituent la contrepartie de la réduction du nombre de verrous de programmation et compliquent la structure de la mémoire. Ainsi, par exemple, une mémoire programmable par mot comprenant 2048 lignes de bit agencées en 256 colonnes doit être équipée de 256 verrous de sélection de colonnes et de 256 verrous de sélection de lignes de bit. Les verrous comprennent chacun un élément de verrouillage du signal de sélection SELₖ afin que les signaux délivrés CGSₖ et BLSₖ restent stables jusqu'à ce qu'un signal de remise à zéro soit appliqué aux verrous.

La présente invention a pour objectif de pallier cet inconvénient et de simplifier l'architecture d'une telle mémoire.

La présente invention se fonde sur la constatation selon laquelle l'élément de verrouillage présent dans un verrou de sélection d'une colonne peut être utilisé pour générer et/ou contrôler le signal de sélection des lignes de bit de la colonne, en sus du signal de contrôle de grille destiné aux transistors à grille flottante.

Ainsi, une idée de la présente invention est d'intégrer dans un même verrou ne comportant qu'un seul élément de verrouillage, la fonction de sélection de colonne et la fonction de sélection de lignes de bit, en prévoyant un verrou à deux sorties, l'une pour délivrer le signal de contrôle de grille et l'autre pour délivrer le signal de sélection de lignes de bit.

Plus particulièrement, la présente invention prévoit une mémoire effaçable et programmable électriquement comprenant des cellules mémoire connectées à des lignes de mot et à des lignes de bit agencées en colonnes(COLₖ), des transistors de sélection de lignes de bit pilotés par des signaux de sélection de lignes de bit, un décodeur de colonne pour délivrer des signaux de sélection de colonne, et des verrous de sélection de colonne recevant chacun un signal de sélection de colonne et délivrant chacun un signal de contrôle de grille appliqué aux cellules mémoire d'une colonne, et comprenant chacun un élément de verrouillage du signal de sélection de colonne et des moyens pour conférer au signal de contrôle de grille une valeur contrôlée par l'élément de verrouillage, dans laquelle chaque verrou de sélection de colonne comprend des moyens pour délivrer, en sus du signal de contrôle de grille, un signal de sélection de lignes de bit dont la valeur est contrôlée par l'élément de verrouillage au moins pendant des phases de programmation et de lecture de cellules mémoire.

Selon un mode de réalisation, un verrou de sélection de colonne dans l'état actif délivre, pendant des périodes de programmation de cellules mémoire, un signal de contrôle de grille égal à zéro et un signal de sélection de lignes de bit égal ou sensiblement égal à une haute tension de programmation.

Selon un mode de réalisation, un verrou de sélection de colonne dans l'état actif délivre, pendant des périodes d'effacement de cellules mémoire, un signal de contrôle de grille égal à une haute tension d'effacement et un signal de sélection de lignes de bit égal à zéro.

Selon un mode de réalisation, un verrou de sélection de colonne dans l'état actif délivre, pendant des périodes d'effacement de cellules mémoire, un signal de contrôle de grille égal à une haute tension d'effacement et un signal de sélection de lignes de bit égal ou sensiblement égal à la haute tension d'effacement.

Selon un mode de réalisation, la mémoire comprend des transistors d'isolement interposés entre les lignes de bit et des sorties de verrous de programmation.

Selon un mode de réalisation, un verrou de sélection de colonne comprend un moyen interrupteur ayant une borne de commande connectée à la sortie de l'élément de verrouillage, une borne d'entrée recevant une tension de contrôle de grille et une borne de sortie délivrant le signal de contrôle de grille.

Selon un mode de réalisation, un verrou de sélection de colonne comprend une piste conductrice dont une extrémité est connectée à la sortie de l'élément de verrouillage et dont l'autre extrémité délivre le signal de sélection de lignes de bit.

Selon un mode de réalisation, un verrou de sélection de colonne comprend un second moyen interrupteur ayant une borne de commande connectée à la sortie de l'élément de verrouillage, une borne d'entrée recevant une tension déterminée, et une borne de sortie délivrant le signal de sélection de lignes de bit.

Selon un mode de réalisation, un verrou de sélection de colonne comprend une porte inverseuse alimentée électriquement par une tension déterminée, dont l'entrée est connectée à un noeud de l'élément de verrouillage et dont la sortie délivre le signal de sélection de lignes de bit.

Selon un mode de réalisation, la tension déterminée est identique à une tension d'alimentation appliquée à l'élément de verrouillage.

Selon un mode de réalisation, la tension déterminée est une tension nulle pendant des phases d'effacement de cellules mémoire.

La présente invention concerne également un procédé pour sélectionner des lignes de bit dans une mémoire effaçable et programmable électriquement, comprenant des cellules mémoire connectées à des lignes de mot et à des lignes de bit agencées en colonnes(COLₖ), des transistors de sélection de lignes de bit pilotés par des signaux de sélection de lignes de bit, un décodeur de colonne pour délivrer des signaux de sélection de colonne, et des verrous de sélection de colonne recevant chacun un signal de sélection de colonne et délivrant chacun un signal de contrôle de grille appliqué aux cellules mémoire d'une colonne, et comprenant chacun un élément de verrouillage du signal de sélection de colonne et des moyens pour conférer au signal de contrôle de grille une valeur contrôlée par l'élément de verrouillage, procédé dans lequel on prévoit dans chaque verrou de sélection de colonne des moyens pour délivrer, en sus du signal de contrôle de grille, un signal de sélection de lignes de bit dont la valeur est contrôlée par l'élément de verrouillage au moins pendant des phases de programmation et de lecture de cellules mémoire.

Selon un mode de réalisation, le procédé comprend la prévision dans un verrou de sélection de colonne d'un moyen interrupteur ayant une borne de commande connectée à la sortie de l'élément de verrouillage, une borne d'entrée recevant une tension déterminée, et une borne de sortie délivrant le signal de sélection de lignes de bit.

Selon un mode de réalisation, le procédé comprend la prévision dans un verrou de sélection de colonne d'une porte inverseuse alimentée électriquement par une tension déterminée, dont l'entrée est connectée à un noeud de l'élément de verrouillage et dont la sortie délivre le signal de sélection de lignes de bit.

Selon un mode de réalisation, la tension déterminée est choisie identique à une tension d'alimentation appliquée à l'élément de verrouillage.

Selon un mode de réalisation, la tension déterminée est une tension nulle pendant des phases d'effacement de cellules mémoire.

Selon un mode de réalisation, le procédé comprend la prévision de transistors d'isolement interposés entre les lignes de bit et des sorties des verrous de programmation.

Ces objets, caractéristiques et avantages ainsi que d'autres de la présente invention seront exposés plus en détail dans la description suivante d'un exemple de réalisation d'une mémoire selon l'invention, faite à titre non limitatif en relation avec les figures jointes parmi lesquelles :
- la figure 1 précédemment décrite représente l'architecture classique d'une mémoire EEPROM programmable par mot,
- la figure 2 représente un mode de réalisation classique d'un verrou de sélection de colonne dans une mémoire EEPROM programmable par mot,
- la figure 3 représente un mode de réalisation classique d'un verrou de sélection de lignes de bit dans une mémoire EEPROM programmable par mot,
- la figure 4 représente un mode de réalisation d'un verrou de sélection de colonne selon l'invention,
- la figure 5 représente l'architecture d'une mémoire EEPROM programmable par mot comprenant des verrous de sélection de colonne selon l'invention,
- les figures 6A, 6B et 6C représentent des tensions électriques apparaissant dans la mémoire selon l'invention pendant des phases d'effacement, de programmation et de lecture, et
- les figures 7 et 8 représentent des variantes de réalisation de verrous de sélection de colonne selon l'invention.

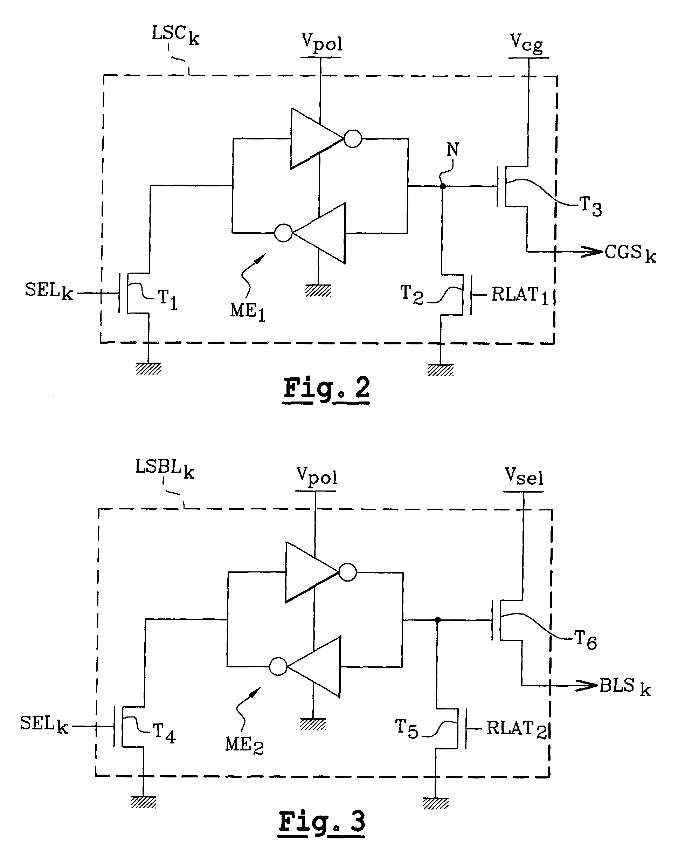

La figure 2 représente un mode de réalisation classique d'un verrou de sélection de colonne LSCₖ et la figure 3 représente un mode de réalisation classique d'un verrou de sélection de lignes de bit LSBLₖ, ces deux éléments étant utilisés dans la mémoire MEM1 décrite au préambule en relation avec la figure 1.

Le verrou LSCₖ comprend un élément de verrouillage ME1 prenant généralement la forme d'une cellule mémoire inverseuse, formée par deux portes inverseuses connectées tête-bêche et alimentées par une tension Vpol. L'entrée de la cellule ME1 est reliée à la masse par un transistor NMOS T1 dont la grille est pilotée par le signal de sélection de colonne SELₖ délivré par le décodeur de colonne CDEC (Cf. fig. 1). La sortie de la cellule mémoire ME1 est reliée à la masse par l'intermédiaire d'un transistor NMOS T2 dont la grille est pilotée par un signal de remise à zéro RLAT1 ("Reset Latch"). La sortie de la cellule mémoire ME1 pilote la grille d'un transistor NMOS T3 recevant sur son drain une tension de contrôle de grille Vcg et délivrant sur sa source le signal de contrôle de grille CGSₖ décrit plus haut (appliqué à des transistors à grille flottante FGT par l'intermédiaire d'un transistor de contrôle de grille CGT_{i,k}, Cf. fig. 1).

Le verrou LSBLₖ comprend un élément de verrouillage ME2, ici une cellule inverseuse à mémoire du type précité formée par deux portes inverseuses connectées tête-bêche et alimentées par la tension Vpol. L'entrée de la cellule ME2 est reliée à la masse par un transistor NMOS T4 dont la grille est pilotée par le signal de sélection de colonne SELₖ. La sortie de la cellule mémoire ME2 est reliée à la masse par l'intermédiaire d'un transistor NMOS T5 dont la grille est pilotée par un signal de remise à zéro RLAT2. La sortie de la cellule mémoire ME2 pilote la grille d'un transistor NMOS T6 recevant sur son drain une tension Vsel délivrant sur sa source un signal de sélection de lignes de bit BLSₖ appliqué aux transistors de sélection de lignes de bit TSBL0 à TSBL7 (Cf. fig. 1).

Pendant des phases d'effacement de cellules mémoire, les tensions Vpol et Vcg sont égales à Vpp et la tension Vsel est nulle. Pendant des phases de programmation, les tensions Vpol et Vsel sont égales à Vpp et la tension Vcg est nulle. Pendant des phases de lecture, les tensions Vpol et Vsel sont égales à une tension Vcc, la tension Vcc étant généralement la tension d'alimentation de la mémoire, et la tension Vcg est choisie sensiblement égale à une tension de lecture Vread.

Afin de simplifier l'architecture d'une mémoire EEPROM programmable par mot, la présente invention propose d'intégrer les deux verrous LSCₖ et LSBLₖ dans un seul et même verrou comprenant une entrée pour recevoir le signal de sélection SELₖ et deux sorties pour délivrer respectivement le signal de contrôle de grille CGSₖ et le signal de sélection de lignes de bit BLSₖ.

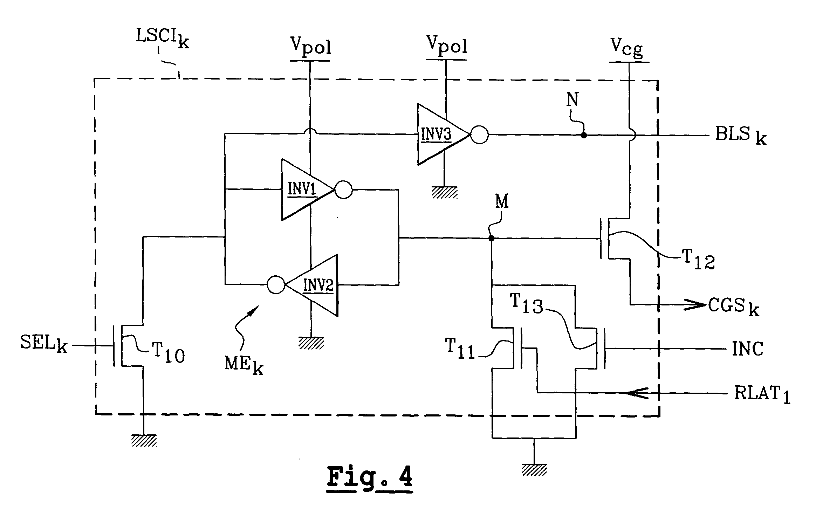

La figure 4 représente un mode de réalisation d'un verrou LSCIₖ selon l'invention. Le verrou LSCIₖ comprend un élément de verrouillage MEₖ prenant par exemple la forme d'une cellule mémoire inverseuse formée par deux portes inverseuses INV1, INV2 connectées tête-bêche et alimentées par la tension Vpol. L'entrée de la cellule MEₖ est reliée à la masse par un transistor NMOS T10 dont la grille est pilotée par le signal de sélection de colonne SELₖ. Ainsi, quand le signal SELₖ passe à 1, la sortie de la cellule MEₖ passe également à 1. La sortie de la cellule MEₖ est reliée à la masse par l'intermédiaire d'un transistor NMOS T11 dont la grille est pilotée par un signal de remise à zéro RLAT. Par ailleurs, la sortie de la cellule mémoire MEₖ pilote la grille d'un transistor NMOS T12 recevant sur son drain la tension de contrôle de grille Vcg et délivrant sur sa source le signal de contrôle de grille CGSₖ. Selon l'invention, l'entrée de la cellule MEₖ est connectée à l'entrée d'une porte inverseuse INV3 alimentée par la tension Vpol, dont la sortie délivre le signal de sélection de lignes de bit BLSₖ. La cellule MEₖ étant bidirectionnelle du fait que les portes inverseuses INV1, INV2 soient connectées tête-bêche, on notera que son entrée peut être considérée comme une sortie.

De façon optionnelle, le verrou LSCIₖ comprend également un transistor NMOS T13 agencé en parallèle avec le transistor T11 et piloté par un signal INC. Ce signal INC, distinct du signal RLAT, permet une remise à zéro en cascade de verrous agencés dans diverses colonnes pendant une lecture séquentielle de toute une page de la mémoire, avec balayage des adresses de colonne.

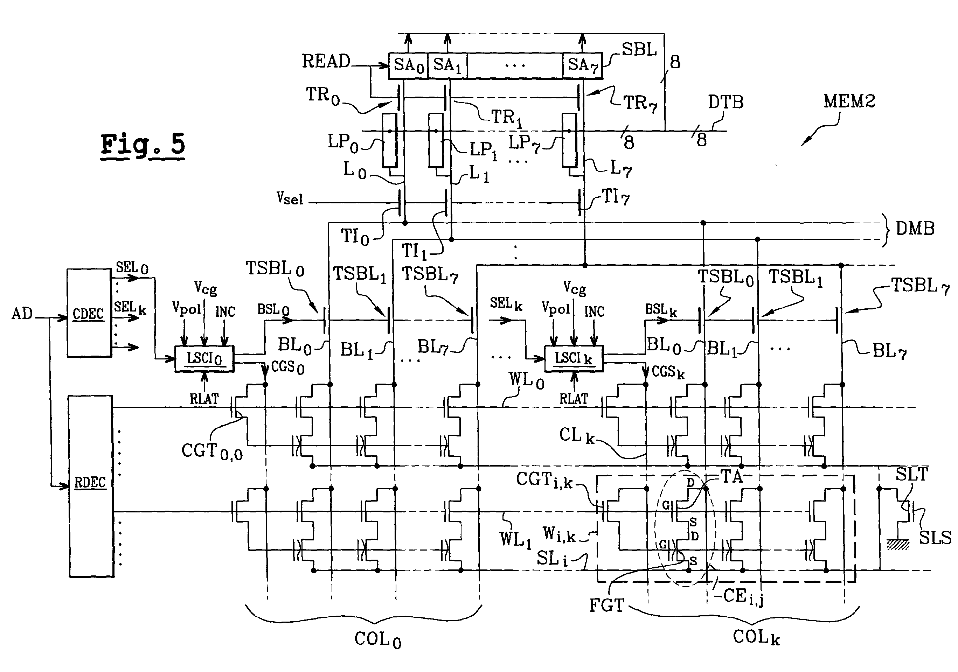

La figure 5 représente une mémoire MEM2 incorporant des verrous LSCIₖ selon l'invention. La mémoire MEM2 présente de façon générale la même structure que la mémoire MEM1 de la figure 1 et ne sera pas décrite à nouveau, les divers éléments étant désignés par les mêmes références.

La mémoire MEM2 se distingue de la mémoire classique MEM1 par le fait que les verrous de sélection de colonne LSCₖ ainsi que les verrous de sélection de lignes de bit LSBLₖ sont supprimés et remplacés par des verrous LSCIₖ selon l'invention, qui délivrent dans chaque colonne le signal de contrôle de grille CGSₖ et le signal de sélection de lignes de bit BLSₖ.

La mémoire MEM2 comprend également huit transistors d'isolement TI0 à TI7 agencés sur les lignes L0 à L7, en aval des sorties des verrous de programmation LP0 à LP7 et en amont du bus de démultiplexage DMB. Les grilles des transistors d'isolement sont pilotées par la tension Vsel mentionnée plus haut en relation avec la figure 3.

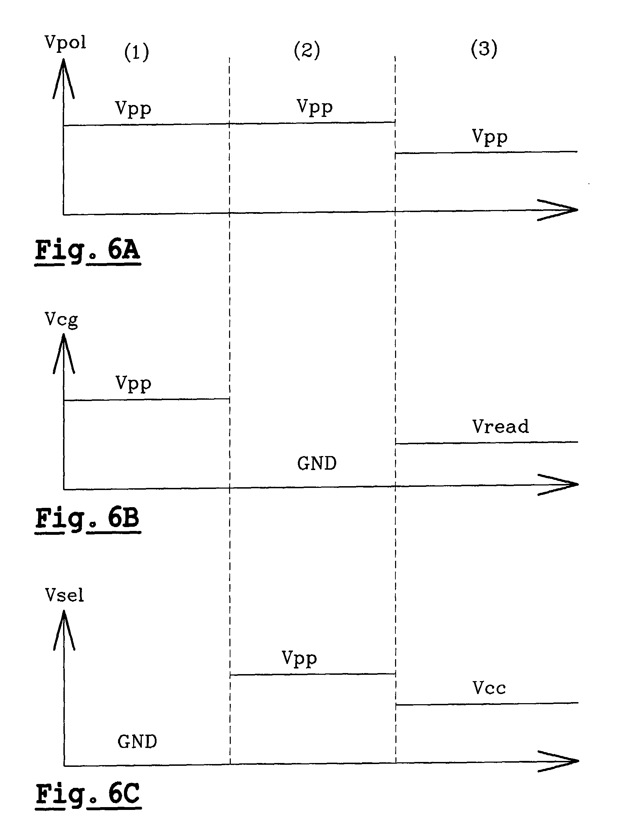

Les figures 6A, 6B et 6C représentent respectivement les valeurs des tensions Vpol, Vcg et Vsel pendant les phases d'effacement (1) de programmation (2) et de lecture (3). Pendant les phases d'effacement, les tensions Vpol et Vcg sont égales à la haute tension Vpp et la tension Vsel est à zéro (masse). Pendant les phases de programmation (2), les tensions Vpol et Vsel sont égales à la haute tension Vpp et la tension Vcg est à zéro. Pendant les phases de lecture (3), les tensions Vpol et Vsel sont égales à la tension d'alimentation Vcc de la mémoire et la tension Vcg est égale à la tension de lecture Vread.

La mémoire MEM2 fonctionne ainsi comme suit. Pendant une phase d'effacement des cellules mémoire d'un mot W_{i,k}, la ligne de mot correspondante WLᵢ est portée à la tension Vpp par le décodeur RDEC. Le verrou LSCIₖ de la colonne COLₖ est activé par le signal SELₖ délivré par le décodeur CDEC et délivre un signal de contrôle de grille CGSₖ et un signal de sélection de lignes de bit BLSₖ égaux à Vpp. Les transistors de sélection TSBLₖ étant passants, l'isolement des lignes de bit BLⱼ relativement aux sorties des verrous de programmation LPⱼ est assuré ici par les transistors d'isolement TIⱼ car la tension Vsel est nulle. Parallèlement, la ligne de source SLᵢ est connectée à la masse par le transistor SLT. Les transistors à grille flottante FGT du mot W_{i,k} reçoivent la tension d'effacement Vpp sur leur grille par l'intermédiaire du transistor de contrôle de grille CGT_{i,k} et leur source est portée à la masse, ce qui provoque une extraction des charges piégées dans les grilles flottantes et l'effacement des transistors FGT .

Pendant une phase de programmation des cellules mémoire d'un mot W_{i,k}, les verrous de programmation LP0 à LP7 délivrent une haute tension de programmation Vpp ou une tension nulle selon la valeur des bits qui y ont été préalablement chargés par l'intermédiaire du bus de données DTB. La ligne de mot WLᵢ est portée à la tension Vpp par le décodeur RDEC. Le verrou LSCIₖ est activé par le signal SELₖ et délivre à nouveau un signal de contrôle de grille CGSₖ et un signal de sélection de lignes de bit BLSₖ égaux à Vpp. Les transistors TSBLⱼ de la colonne et les transistors d'isolement TIⱼ laissent passer la tension Vpp délivrée par les verrous de programmation dans les lignes de bit de la colonne. Les transistors à grille flottante FGT ont leurs grilles portées à la masse par l'intermédiaire du transistor de contrôle de grille CGT_{i,k} du mot W_{i,k}, (Vcg=0). La ligne de source SLᵢ est portée à un potentiel flottant. Les transistors FGT reçoivent ainsi sur leur drain la tension Vpp ou la tension nulle délivrée par un verrou de programmation, et ceux qui reçoivent la tension Vpp sont programmés par effet tunnel et injection de charge dans leur grille flottante.

Pendant une phase de lecture des cellules mémoire d'un mot W_{i,k}, le verrou LSCIₖ est activé par le signal de sélection SELₖ et délivre un signal de contrôle de grille CGSₖ égal à Vread (Vcg = Vread) et un signal de sélection de lignes de bit BLSₖ égal à Vcc (Vpol = Vcc). Les transistors TSBLⱼ de la colonne sont ainsi passants et laissent passer la tension Vcc délivrée par les amplificateurs de lecture SA0 à SA7 dans les lignes de bit concernées. La ligne de mot WLᵢ est portée à la tension Vcc par le décodeur RDEC. La ligne de source SLᵢ est portée à la masse. Les transistors à grille flottante du mot W_{i,k} ont leur grille portée à la tension Vread par l'intermédiaire du transistor de contrôle de grille CGT_{i,k} et leur état passant ou bloqué est détecté par les amplificateurs de lecture SA0 à SA7.

La présente invention est bien entendu susceptible de diverses variantes de réalisation.

Tout d'abord, comme on le voit sur la figure 4, un noeud N en sortie de la porte inverseuse INV3 présente la même valeur logique "1" (Vpol) ou "0" (masse) qu'un noeud M en sortie de la cellule inverseuse MEₖ. Ainsi, dans une variante de réalisation, le signal BLSₖ peut être prélevé directement sur le noeud M au moyen d'une simple piste conductrice. Le signal BLSₖ étant toutefois appliqué à huit transistors TSBL0 à TSBL7, le prélèvement de ce signal à la sortie de la cellule MEₖ nécessite une augmentation des dimensions des transistors formant les portes INV1 et INV2 (non représentées), de manière que la cellule MEₖ soit capable de délivrer un courant suffisant pour charger simultanément et rapidement les capacités parasites de grille de tous les transistors. Il est apparu plus simple de connecter la porte inverseuse INV3 à un noeud L situé à l'entrée de la cellule MEₖ sans modifier la structure de la cellule MEₖ par rapport à celle d'un verrou de sélection de colonne classique, cette entrée étant équivalente à une sortie comme expliqué plus haut.

Dans un mode de réalisation de la mémoire selon l'invention, les transistors d'isolement TI0 à TI7 sont intégrés dans les verrous de programmation LP0 à LP7 et ne se trouvent plus sur le chemin reliant les lignes de bits aux entrées des amplificateurs de lecture. Il n'est alors plus nécessaire, en mode lecture, de rendre passants les transistors d'isolement.

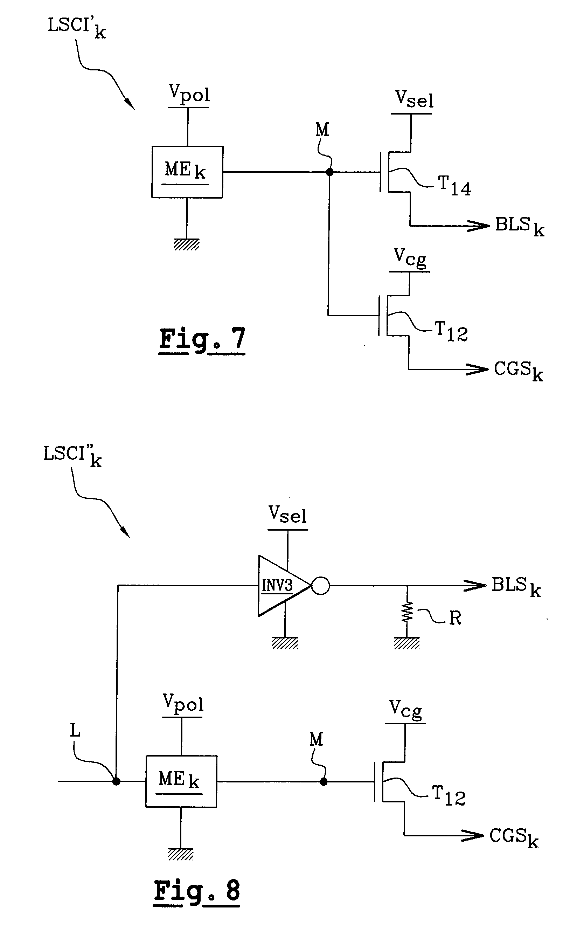

Dans un mode de réalisation d'un verrou LSCI'ₖ selon l'invention, représenté en figure 7, la sortie de la cellule MEₖ pilote, outre le transistor T12 délivrant le signal de contrôle de grille CGSₖ, un transistor NMOS T14 qui reçoit sur son drain la tension Vsel et délivre le signal de sélection de lignes de bit BLSₖ. Dans ce mode de réalisation, le signal de sélection de lignes de bit BLSₖ est à zéro (masse) pendant les phases d'effacement et les transistors d'isolement TI0 à TI7 ne sont plus nécessaires.

Le verrou LSCIₖ représenté en figure 4 présente toutefois l'avantage, par rapport à celui de la figure 7, de ne pas recevoir la tension Vsel qui n'est donc pas utilisée pour générer le signal BLSₖ délivré par le verrou. Le signal BLSₖ est ainsi égal à Vpp pendant les périodes d'effacement et les transistors de sélection de lignes de bit TSBLⱼ sont passants. Ceci est compensé par la prévision des transistors d'isolement TI0 à TI7 pilotés par la tension Vsel, qui sont bloqués pendant les périodes d'effacement quand la tension Vsel est égale à 0. Le verrou de sélection de colonne LSCIₖ de la figure 4 ne comprend ainsi pas de transistor de commutation de la tension Vsel comme le transistor T14 du verrou de la figure 7.

Cette caractéristique est avantageuse quand le nombre de verrous LSCIₖ est supérieur à huit, ce qui est généralement le cas en pratique et permet de supprimer autant de transistors de commutation de la tension Vsel que de verrous LSCIₖ présents dans la mémoire, par exemple 256 transistors supprimés (un par verrou LSCIₖ) dans une mémoire de 256 colonnes et de 256 verrous LSCIₖ.

Toutefois, l'avantage principal de la présente invention réside dans la suppression des verrous de sélection de lignes de bit et des éléments de verrouillage qu'ils comprennent, et le mode de réalisation de la figure 7 entre dans le cadre de la présente invention.

Comme autre variante envisageable, la figure 8 représente un verrou LSCI"ₖ selon l'invention dans lequel la porte inverseuse INV3 est alimentée par la tension Vsel et a sa sortie connectée à la masse par une résistance de rappel au niveau bas ("pull-down") de forte valeur. Dans ce mode de réalisation, le signal de sélection de lignes de bit BLSₖ est également à la masse pendant les périodes d'effacement car le signal Vsel est à zéro et la porte INV3 n'est pas alimentée électriquement. Les transistors d'isolement TI0 à TI7 ne sont également pas nécessaires avec ce mode de réalisation.

Il apparaîtra clairement à l'homme de l'art que divers autres modes de réalisation sont envisageables pour réaliser un verrou de colonne selon l'invention, dont la caractéristique principale est de délivrer un signal de contrôle de grille CGSₖ et un signal de sélection de lignes de bit BLSₖ qui sont contrôlés par la sortie d'un seul et unique élément MEₖ assurant le verrouillage du signal de sélection de colonne SELₖ.

## Revendications

1. Mémoire effaçable et programmable électriquement comprenant :
- des cellules mémoire (CE_{i,j}) connectées à des lignes de mot (WLᵢ) et à des lignes de bit (BLⱼ) agencées en colonnes (COLₖ),
- des transistors de sélection de lignes de bit (TSBLⱼ) pilotés par des signaux de sélection de lignes de bit (BLSₖ),
- un décodeur de colonne (CDEC) pour délivrer des signaux de sélection de colonne (SELₖ), et
- des verrous de sélection de colonne (LSCIₖ) recevant chacun un signal de sélection de colonne (SELₖ) et délivrant chacun un signal de contrôle de grille (CGSₖ) appliqué aux cellules mémoire d'une colonne, et comprenant chacun un élément de verrouillage (MEₖ) du signal de sélection de colonne (SELₖ) et des moyens (T12) pour conférer au signal de contrôle de grille (CGSₖ) une valeur contrôlée par l'élément de verrouillage,
**caractérisée en ce que** chaque verrou de sélection de colonne (LSCIₖ) comprend des moyens (INV3, T14) pour délivrer, en sus du signal de contrôle de grille (CGSₖ), un signal de sélection de lignes de bit (BLSₖ) dont la valeur est contrôlée par l'élément de verrouillage (MEₖ) au moins pendant des phases de programmation et de lecture de cellules mémoire.

2. Mémoire selon la revendication 1 dans laquelle un verrou de sélection de colonne (LSCIₖ) dans l'état actif délivre, pendant des périodes de programmation de cellules mémoire, un signal de contrôle de grille (CGSₖ) égal à zéro et un signal de sélection de lignes de bit (BLSₖ) égal ou sensiblement égal à une haute tension de programmation (Vpp).

3. Mémoire selon l'une des revendications 1 et 2 dans laquelle un verrou de sélection de colonne (LSCIₖ) dans l'état actif délivre, pendant des périodes d'effacement de cellules mémoire, un signal de contrôle de grille (CGSₖ) égal à une haute tension d'effacement (Vpp) et un signal de sélection de lignes de bit (BLSₖ) égal à zéro.

4. Mémoire selon l'une des revendications 1 et 2 dans laquelle un verrou de sélection de colonne (LSCIₖ) dans l'état actif délivre, pendant des périodes d'effacement de cellules mémoire, un signal de contrôle de grille (CGSₖ) égal à une haute tension d'effacement (Vpp) et un signal de sélection de lignes de bit (BLSₖ) égal ou sensiblement égal à la haute tension d'effacement.

5. Mémoire selon l'une des revendications 1 à 4, comprenant des transistors d'isolement (TIj) interposés entre les lignes de bit et des sorties de verrous de programmation (LPj).

6. Mémoire selon l'une des revendications 1 à 5, dans laquelle un verrou de sélection de colonne (LSCIₖ) comprend un moyen interrupteur (T12) ayant une borne de commande connectée à la sortie (M) de l'élément de verrouillage (MEₖ), une borne d'entrée recevant une tension de contrôle de grille (Vcg) et une borne de sortie délivrant le signal de contrôle de grille (CGSₖ).

7. Mémoire selon l'une des revendications 1 à 6, dans laquelle un verrou de sélection de colonne (LSCIₖ) comprend une piste conductrice dont une extrémité est connectée à la sortie (M) de l'élément de verrouillage (MEₖ) et dont l'autre extrémité délivre le signal de sélection de lignes de bit (BLSₖ).

8. Mémoire selon l'une des revendications 1 à 6, dans laquelle un verrou de sélection de colonne (LSCIₖ) comprend un second moyen interrupteur (T14) ayant une borne de commande connectée à la sortie (M) de l'élément de verrouillage (MEₖ), une borne d'entrée recevant une tension déterminée (Vsel), et une borne de sortie délivrant le signal de sélection de lignes de bit (BLSₖ).

9. Mémoire selon l'une des revendications 1 à 6, dans laquelle un verrou de sélection de colonne (LSCIₖ) comprend une porte inverseuse (INV3) alimentée électriquement par une tension déterminée (Vpol, Vsel), dont l'entrée est connectée à un noeud (L) de l'élément de verrouillage (MEₖ) et dont la sortie délivre le signal de sélection de lignes de bit (BLSₖ).

10. Mémoire selon la revendication 9, dans laquelle la tension déterminée (Vpol) est identique à une tension d'alimentation (Vpol) appliquée à l'élément de verrouillage.

11. Mémoire selon l'une des revendications 8 et 9, dans laquelle la tension déterminée (Vsel) est une tension nulle pendant des phases d'effacement de cellules mémoire.

12. Procédé pour sélectionner des lignes de bit (BLⱼ) dans une mémoire effaçable et programmable électriquement comprenant :
- des cellules mémoire (CE_{i,j}) connectées à des lignes de mot (WLᵢ) et à des lignes de bit (BLⱼ) agencées en colonnes (COLₖ),
- des transistors de sélection de lignes de bit (TSBLⱼ) pilotés par des signaux de sélection de lignes de bit (BLSₖ),
- un décodeur de colonne (CDEC) pour délivrer des signaux de sélection de colonne (SELₖ), et
- des verrous de sélection de colonne (LSCIₖ) recevant chacun un signal de sélection de colonne (SELₖ) et délivrant chacun un signal de contrôle de grille (CGSₖ) appliqué aux cellules mémoire d'une colonne, et comprenant chacun un élément de verrouillage (MEₖ) du signal de sélection de colonne (SELₖ) et des moyens (T12) pour conférer au signal de contrôle de grille (CGSₖ) une valeur contrôlée par l'élément de verrouillage,
**caractérisé en ce que** l'on prévoit dans chaque verrou de sélection de colonne (LSCIₖ) des moyens (INV3, T14) pour délivrer, en sus du signal de contrôle de grille (CGSₖ), un signal de sélection de lignes de bit (BLSₖ) dont la valeur est contrôlée par l'élément de verrouillage (MEₖ) au moins pendant des phases de programmation et de lecture de cellules mémoire.

13. Procédé selon la revendication 12, comprenant la prévision dans un verrou de sélection de colonne (LSCIₖ) d'un moyen interrupteur (T14) ayant une borne de commande connectée à la sortie (M) de l'élément de verrouillage (MEₖ), une borne d'entrée recevant une tension déterminée (Vsel), et une borne de sortie délivrant le signal de sélection de lignes de bit (BLSₖ).

14. Procédé selon la revendication 12, comprenant la prévision dans un verrou de sélection de colonne (LSCIₖ) d'une porte inverseuse (INV3) alimentée électriquement par une tension déterminée (Vpol, Vsel), dont l'entrée est connectée à un noeud (L) de l'élément de verrouillage (MEₖ) et dont la sortie délivre le signal de sélection de lignes de bit (BLSₖ).

15. Procédé selon la revendication 14, dans lequel la tension déterminée (Vpol) est choisie identique à une tension d'alimentation (Vpol) appliquée à l'élément de verrouillage.

16. Procédé selon l'une des revendications 13 et 14, dans lequel la tension déterminée (Vsel) est une tension nulle pendant des phases d'effacement de cellules mémoire.

17. Procédé selon l'une des revendications 12 à 16, comprenant la prévision de transistors d'isolement (TIj) interposés entre les lignes de bit et des sorties des verrous de programmation (LPj).
